# EUROPEAN PATENT APPLICATION

(11) **EP 4 764 558 A1**
(43) Date of publication of application: **24.06.2026**
(21) Application number: 24897813.2
(22) Date of filing: 23.08.2024
(51) Int. Cl.: G01R 31/396, G01R 31/385, G01R 31/36, G01R 19/175, G01R 19/165, G01R 19/10

(54) **BATTERY MANAGEMENT APPARATUS AND OPERATING METHOD THEREOF**

(30) Priority: 01.12.2023 KR 20230172719
(71) Applicant: LG Energy Solution, Ltd., Seoul 07335 (KR)
(72) Inventor: IN, Yong Ha, Daejeon 34122 (KR); LEE, Seung Hyun, Daejeon 34122 (KR)
(74) Representative: Goddar, Heinz J.
(86) International application number: PCT/KR2024/012585
(87) International publication number: WO 2025/116212

(57) **Abstract**

A battery management apparatus according to an embodiment disclosed herein includes a data obtaining unit configured to obtain voltage data related to a voltage change with respect to time for each of a plurality of battery cells, a pre-processing unit configured to obtain reconstructed voltage data in a predetermined time section from a data set comprising the voltage data of each of the plurality of battery cells, by using a data decomposition algorithm, a noise processing unit configured to generate battery cell data by performing noise processing based on characteristics of the reconstructed voltage data, and an abnormal cell detection unit configured to detect an abnormal battery cell based on the voltage deviation of each of the battery cell data.

## Description

### Technical Field

### CROSS-REFERENCE TO RELATED APPLICATION

This application claims priority to and the benefit of Korean Patent Application No. 10-2023-0172719 filed in the Korean Intellectual Property Office on December 1, 2023, the entire content of which is incorporated herein by reference.

### TECHNICAL FIELD

Embodiments disclosed herein relate to a battery management apparatus and an operating method thereof.

### Background Art

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Recently, the lithium-ion battery is attracting attention as a next-generation energy storage medium as a usage range thereof is expanded to a power source of electric vehicles.

An electric vehicle is supplied with electricity from outside to charge a battery cell/module, and then the battery cell/module is discharged to drive a motor and obtain power. The battery cell/module undergoes internal deformation and denaturation through various chares/discharges in production and use phases, such that physical and chemical characteristics thereof change. A technique for diagnosing and managing operations of the battery cell/module due to degradation and deterioration of a battery is required.

For various purposes such as performance diagnosis, state analysis, etc., of the battery, a charging/discharging test may be conducted on the battery. For example, a test voltage may be applied to the battery, and a test result voltage may be measured from the battery in response to the test voltage. However, actually measured voltage data includes noise and an error, such that data for managing the state of the battery may not be clearly analyzed.

### Disclosure

### Technical Problem

Embodiments disclosed herein aim to provide a battery management apparatus and an operating method thereof in which an abnormal battery cell may be managed based on voltage data obtained from a battery unit included in a battery pack.

Embodiments disclosed herein aim to provide a battery management apparatus and an operating method thereof based on a data processing algorithm for reducing an influence of noise included in voltage data.

Technical problems of the embodiments disclosed herein are not limited to the above-described technical problems, and other unmentioned technical problems would be clearly understood by one of ordinary skill in the art from the following description.

### Technical Solution

A battery management apparatus according to an embodiment disclosed herein includes a data obtaining unit configured to obtain voltage data related to a voltage change with respect to time for each of a plurality of battery cells, a pre-processing unit configured to obtain reconstructed voltage data in a predetermined time section from a data set including the voltage data of each of the plurality of battery cells, by using a data decomposition algorithm, a noise processing unit configured to generate battery cell data by performing noise processing based on characteristics of the reconstructed voltage data, and an abnormal cell detection unit configured to detect an abnormal battery cell based on the voltage deviation of each of the battery cell data.

According to an embodiment, the pre-processing unit may be further configured to generate a plurality of sub data sets having a length corresponding to the predetermined time section from the data set and obtain the reconstructed voltage data from each of the plurality of sub data sets based on the data decomposition algorithm.

According to an embodiment, the data decomposition algorithm may include a singular value decomposition (SVD) algorithm.

According to an embodiment, the noise processing unit may be further configured to perform the noise processing with respect to each of the reconstructed voltage data based on a number of times of zero crossing that is a number of times a voltage traverses a specific voltage level.

According to an embodiment, the noise processing unit may be further configured to compare the number of times of zero crossing of each of the reconstructed voltage data with a first threshold value, detect, as a noise component, reconstructed data having the number of times of zero crossing being greater than or equal to the first threshold value, and generate the battery cell data by canceling the noise component from the reconstructed voltage data.

According to an embodiment, the specific voltage level may include 0.

According to an embodiment, the noise processing unit may be further configured to perform the noise processing with respect to each of the reconstructed voltage data based on a zero-crossing period that is a period in which a voltage traverses a specific voltage level.

According to an embodiment, the noise processing unit may be further configured to compare the zero-crossing period of each of the reconstructed voltage data with a second threshold value, detect, as a noise component, reconstructed data having a zero-crossing period being less than or equal to the second threshold value, and generate the battery cell data by canceling the noise component from the reconstructed voltage data.

According to an embodiment, the specific voltage level may include 0.

According to an embodiment, the abnormal cell detection unit may be further configured to compare the voltage deviation, which is a difference between a minimum value and a maximum value of a voltage of each of the battery cell data in the predetermined time section, with a third threshold value and detect, as an abnormal battery cell, a battery cell having the voltage deviation being greater than or equal to the third threshold value.

A battery management method according to an embodiment disclosed herein includes obtaining voltage data related to a voltage change with respect to time for each of a plurality of battery cells, obtaining reconstructed voltage data in a predetermined time section from a data set including the voltage data of each of the plurality of battery cells, by using a data decomposition algorithm, generating battery cell data by performing noise processing based on characteristics of the reconstructed voltage data, and detecting an abnormal battery cell based on the voltage deviation of each of the battery cell data.

According to an embodiment, the obtaining of the reconstructed voltage data may include generating a plurality of sub data sets having a length corresponding to the predetermined time section from the data set and obtaining the reconstructed voltage data from each of the plurality of sub data sets based on the data decomposition algorithm.

According to an embodiment, the data decomposition algorithm may include a singular value decomposition (SVD) algorithm.

According to an embodiment, the generating of the battery cell data may include performing the noise processing with respect to each of the reconstructed voltage data based on a number of times of zero crossing that is a number of times a voltage traverses a specific voltage level.

According to an embodiment, the battery management method may further include comparing the number of times of zero crossing of each of the reconstructed voltage data with a first threshold value, detecting, as a noise component, reconstructed data having the number of times of zero crossing being greater than or equal to the first threshold value, and generating the battery cell data by canceling the noise component from the reconstructed voltage data.

According to an embodiment, the specific voltage level may include 0.

According to an embodiment, the generating of the battery cell data may include performing the noise processing with respect to each of the reconstructed voltage data based on a zero-crossing period that is a period in which a voltage traverses a specific voltage level.

According to an embodiment, the battery management method may further include comparing the zero-crossing period of each of the reconstructed voltage data with a second threshold value, detecting, as a noise component, reconstructed data having a zero-crossing period being less than or equal to the second threshold value, and generating the battery cell data by canceling the noise component from the reconstructed voltage data.

According to an embodiment, the specific voltage level may include 0.

According to an embodiment, the detecting of the abnormal battery cell may include comparing the voltage deviation, which is a difference between a minimum value and a maximum value of a voltage of each of the battery cell data in the predetermined time section, with a third threshold value and detecting, as an abnormal battery cell, a battery cell having the voltage deviation being greater than or equal to the third threshold value.

### Advantageous Effects

A battery diagnosis apparatus and an operating method thereof disclosed herein may manage an abnormal battery cell based on voltage data obtained from a battery unit included in a battery pack.

The battery management apparatus and the operating method thereof according to an embodiment disclosed herein may be based on a data processing algorithm for reducing an influence of noise included in voltage data.

In addition, various effects identified directly or indirectly through this document may be provided.

### Description of Drawings

FIG. 1 shows a battery pack according to an embodiment disclosed herein.
FIG. 2 is a block diagram of a battery management apparatus according to an embodiment disclosed herein.
FIG. 3 is a view showing a data set according to an embodiment disclosed herein.
FIG. 4 is a view showing reconstructed voltage data according to an embodiment disclosed herein.
FIG. 5 is a view showing reconstructed voltage data according to an embodiment disclosed herein.
FIG. 6 is a view showing reconstructed voltage data according to an embodiment disclosed herein.
FIG. 7 is a flowchart showing an operation of a battery management apparatus according to an embodiment disclosed herein.
FIG. 8 is a block diagram showing a hardware configuration of a computing system for performing an operating method of a battery management apparatus, according to an embodiment disclosed herein.

### Mode for Invention

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. In the case of online distribution, at least a part of a computer program product may be at least temporarily stored in a machine-readable storage medium such as a memory of a server of a manufacturer, a server of an application store, or a relay server, or may be generated temporarily.

According to various embodiments of the disclosure, each of the above-described components (e.g., a module or program) may include a single entity or a plurality of entities, some of which may be separately disposed on other components. According to various embodiments of the disclosure, one or more of the above-described components or operations may be omitted or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments of the disclosure, operations performed by a module, a program, or other components may be executed sequentially, in parallel, repeatedly, or heuristically, or one or more of the operations may be executed in a different order or omitted, or one or more other operations may be added.

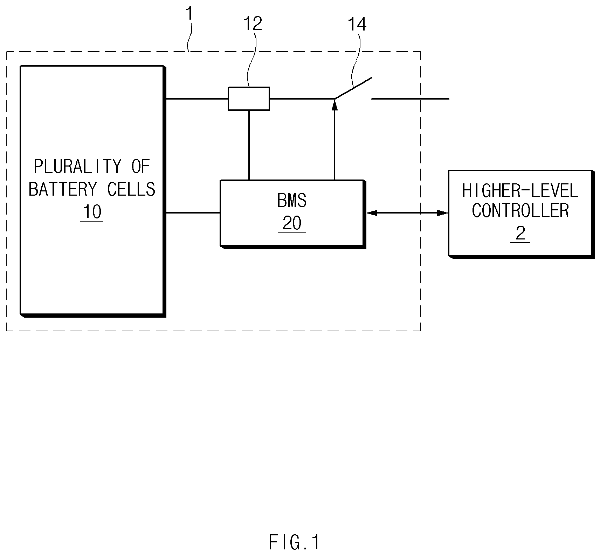

FIG. 1 shows a battery pack according to an embodiment disclosed herein. FIG. 1 schematically shows a battery control system including a battery pack 1 and a higher-level controller 2 included in a higher-level system, according to an embodiment of the present disclosure.

Referring to FIG. 1, the battery pack 1 may include a plurality of battery cells 10, a switching unit 14 serially connected to a positive (+) terminal side and/or a negative (-) terminal side of the plurality of battery cells 10 to control a charging/discharging current flow of the plurality of battery cells 10, and a battery management system (BMS) 20 for control and management to prevent over-charging and over-discharging by monitoring a voltage, a current, a temperature, etc., of the battery pack 1. The battery pack 1 may include the plurality of battery cells 10, a sensor 12, the switching unit 14, and the battery management system 20 provided in plural.

According to an embodiment, the plurality of battery cells 10 may supply power to a target device (not shown). To this end, the plurality of battery cells 10 may be electrically connected to the target device. Herein, the target device may include an electrical, electronic, or mechanical device that operates by receiving power from the battery pack 1. For example, the target device may be, but not limited to, an electric vehicle (EV) or an energy storage system (ESS).

According to an embodiment, the plurality of battery cells 10 may include one or more battery cells. Herein, the battery cell may be a basic unit of a battery cell available through charging/discharging of electric energy. For example, the battery cell may be, but not limited to, a lithium ion (Li-ion) battery, an Li-ion polymer battery, a nickelcadmium (Ni-Cd) battery, a nickel hydrogen (Ni-MH) battery, etc.

According to an embodiment, the sensor 12 may obtain information related to the plurality of battery cells 10. For example, the sensor 12 may obtain values (or information) related to a state of each of the plurality of battery cells 10. Herein, the values related to the state may include one or more values of voltage, current, resistance, state of charge (SOC), state of health (SOH), or temperature of the battery cell or a combination thereof.

According to an embodiment, the sensor 12 may provide information about each of the plurality of battery cells 10 to the battery management system 20.

According to various embodiments, a specific sensor among the sensors 12 respectively connected to the plurality of battery cells 10 may have a higher noise level than another sensor. A specific sensor among the sensors 12 respectively connected to the plurality of battery cells 10 may have a lower signal resolution than another sensor. For a voltage signal of a battery cell obtained from the specific sensor 12 having a high noise level or a low signal resolution, voltage data obtained from the voltage signal measured in the specific sensor 12 may include a part having a greater deviation than actual voltage data of the battery cell.

Thus, in spite of an actual normal voltage behavior of the battery cell, a voltage measured in the specific sensor 12 having a high noise level may show an abnormal behavior. The battery management apparatus 100 may misdiagnose the normal battery cell as an abnormal battery cell based on the measured voltage. Thus, the battery management apparatus 100 may obtain voltage data reconstructed by pre-processing voltage data, perform noise processing on the reconstructed voltage data, and detect the abnormal battery cell based on battery cell data from which noise is canceled. In this way, the battery management apparatus 100 may prevent misdiagnosis due to the noise of the sensor 12.

According to an embodiment, the switching unit 14, which is an element for controlling a current flow for charging or discharging of the plurality of battery cells 10, may include, for example, at least one relay, and/or magnetic contactor according to specifications of the battery pack 1.

According to an embodiment, the battery management system 20, which is an interface for receiving measurement values of the above-described various parameters, may include a plurality of terminals and a circuit, etc., connected thereto to process input values. The battery management system 20 may control on/off of the switching unit 14, e.g., a relay, a contactor, etc., and may be connected to the plurality of battery cells 10 to monitor the state of each of the plurality of battery cells 10.

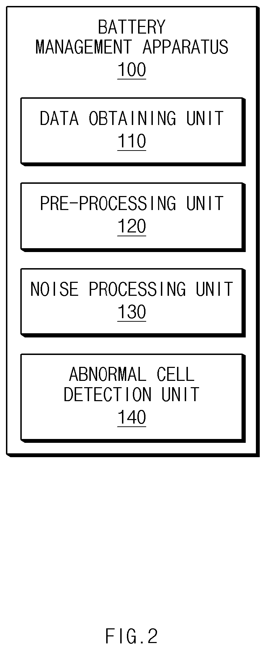

According to an embodiment, the battery management system 20 may include a battery management apparatus 100 of FIG. 2. According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1. The following operation of the battery management apparatus 100 may also be performed in various devices such as not only a battery management system (BMS) in a vehicle, but also a server, a cloud, a charger, a charger/discharger, etc.

The higher-level controller 2 may transmit a control signal regarding the plurality of battery cells 10 to the battery management system 20. Thus, the battery management system 20 may be controlled in terms of an operation thereof based on a signal applied from the higher-level controller 2.

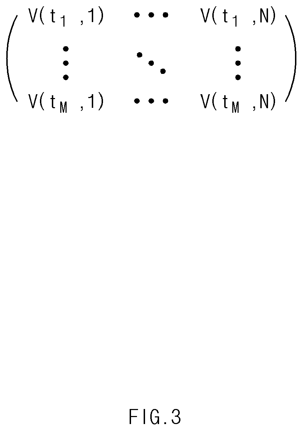

FIG. 2 is a block diagram of a battery management apparatus according to an embodiment disclosed herein. The operation of the battery management apparatus 100 shown in FIG. 2 will be described below in detail with reference to FIGS. 3 to 6

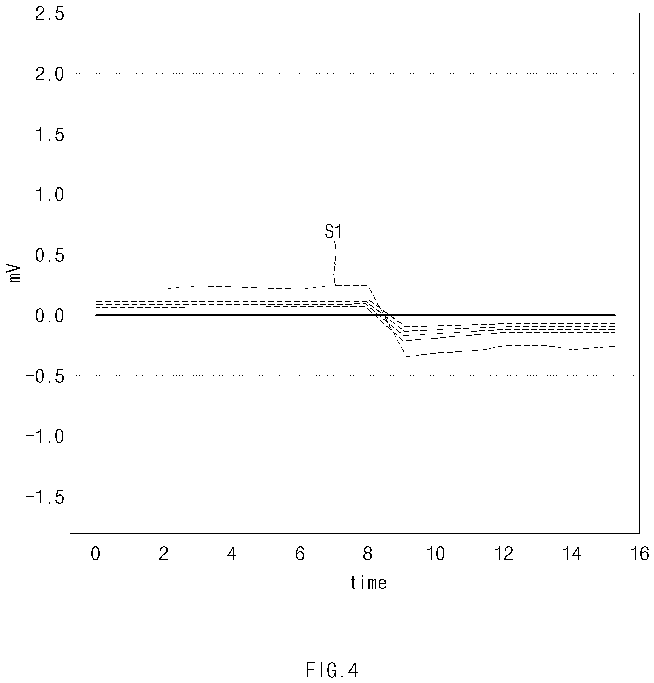

FIG. 3 is a view showing a data set according to an embodiment disclosed herein. FIGS. 4 to 6 are views showing reconstructed voltage data according to an embodiment disclosed herein.

Referring to FIG. 2, the battery management apparatus 100 may be one of various electronic devices for managing, diagnosing, and testing a battery. According to an embodiment, the battery management apparatus 100 may be included in any one of a BMS in a battery pack, a battery management server, a computer, and a cloud server. According to another embodiment, the battery management apparatus 100 may be included in an apparatus for a charging/discharging test such as a charging/discharging cycler.

According to an embodiment, the battery management apparatus 100 may include a data obtaining unit 110, a pre-processing unit 120, a noise processing unit 130, and an abnormal cell detection unit 140.

According to an embodiment, the data obtaining unit 110 may obtain the voltage of each of the plurality of battery cells 10. For example, the data obtaining unit 110 may obtain the voltage of each of the plurality of battery cells 10 in time-series. In another aspect, the data obtaining unit 110 may obtain voltage data of each of the plurality of battery cells 10, related to a voltage change with respect to time. Herein, the voltage change with respect to time may include a voltage change of a battery cell in one or more sections of a charging section, a rest section after charging, a discharging section, and a rest section after discharging.

According to an embodiment, the pre-processing unit 120 may obtain voltage data reconstructed by processing voltage data of the plurality of battery cells 10.

Referring to FIG. 3, the pre-processing unit 120 may manage the voltage data of the plurality of battery cells 10 in the form of a data set. Herein, the data set may be expressed as a matrix (e.g., an M x N matrix) including N voltages (v(t1, 1)..., v(tM, N) of the plurality of battery cells 10 with respect to M time-series values (t1, ..., tM). Herein, M may correspond to a time at which voltages of the plurality of battery cells 10 are obtained, and N may correspond to the number of plurality of battery cells 10. For example, when the number of times (or sensing times of the sensor 12) at which the voltages of the plurality of battery cells 10 are obtained is 180 and the number of plurality of battery cells 10 is 14, M may be 180 and N may be 14.

According to an embodiment, when the data set is expressed as a matrix, each entry (value) of the matrix may indicate the voltage of each of the plurality of battery cells 10. Herein, each column (or column vector) of the data set may indicate a voltage change (e.g., v(t1, 1), ..., v(tM, 1)) obtained at each time point (M time points) of each of the plurality of battery cells 10. Each row (or row vector) of the data set may indicate a voltage (v(t1, 1), ..., v(t1, N)) of each of the plurality of battery cells 10 (N battery cells) obtained at the same time point (or sensing time point).

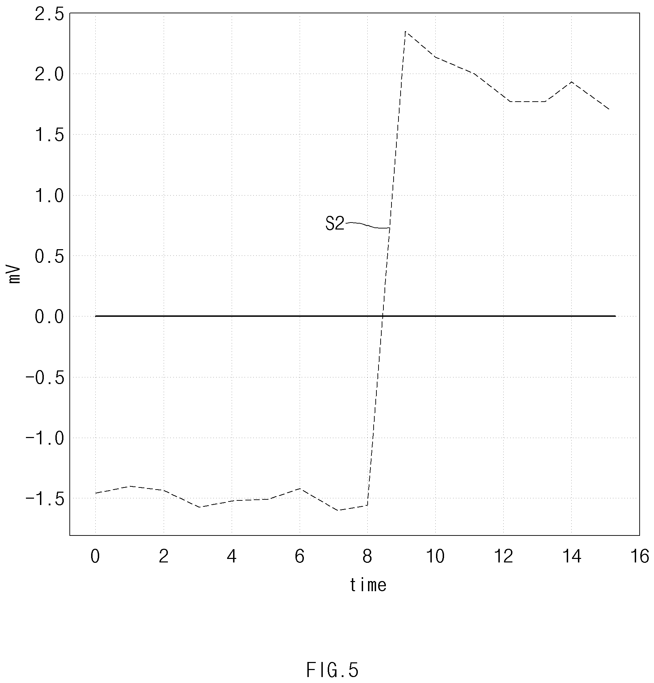

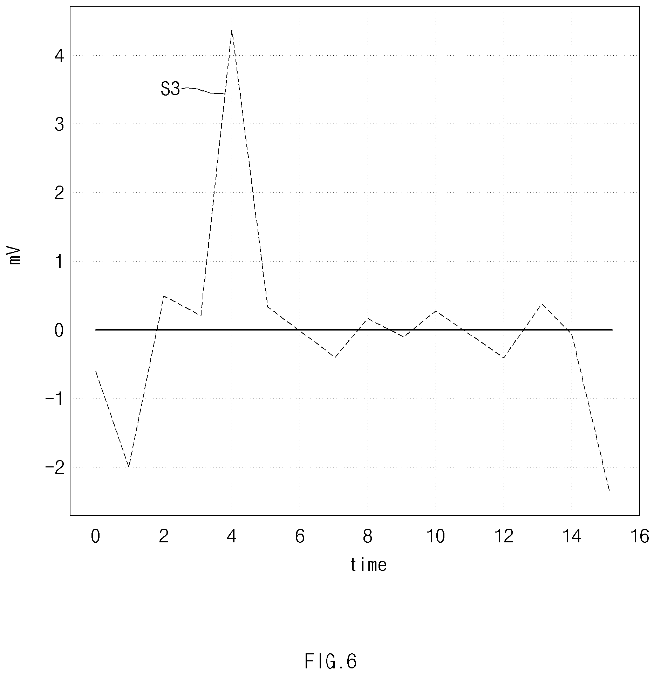

Referring to FIGS. 4 to 6, the pre-processing unit 120 may obtain voltage data reconstructed by processing the data set. For example, FIG. 4 is a graph showing reconstructed voltage data S1 related to a normal battery cell, FIG. 5 is a graph showing reconstructed voltage data S2 related to an abnormal battery cell, and FIG. 6 is a graph showing reconstructed voltage data S3 related to noise.

According to an embodiment, the pre-processing unit 120 may express voltage data reconstructed as a function of a reconstructed voltage for a predetermined time section. In another aspect, the pre-processing unit 120 may express, as the reconstructed voltage data, a graph including a time point (or the sensing time point of the sensor 12) (unit: time) as an x axis and a reconstructed voltage (unit: mV) that is a result value of pre-processing voltage data of each of the plurality of battery cells 10 as a y axis.

According to an embodiment, the pre-processing unit 120 may normalize the voltage data of each of the plurality of battery cells 10 by obtaining data reconstructed based on the data set related to the voltage change of each of the plurality of battery cells 10. For example, the pre-processing unit 120 may obtain the reconstructed data having a normal distribution with an average of 0 and a standard deviation of 1.

According to an embodiment, a voltage of the reconstructed voltage data S1 (see FIG. 4) related to the normal battery cell may be distributed between the average (i.e., 0 mV) of the normal distribution and a point distant therefrom by the standard deviation (i.e., 1 mV). Herein, the reconstructed voltage data S1 related to the normal battery cell may mainly include a value between - 1 mV and 1 mV. On the other hand, the reconstructed voltage data S2 (see FIG. 5) related to the abnormal battery cell or the reconstructed voltage data S3 (see FIG. 6) related to noise of the sensor 12 may include an extreme value in the normal distribution. Herein, the extreme value may mean a value distributed at a point further than the standard deviation from the average of the normal distribution. For example, the extreme value may mean a voltage of the reconstructed voltage data, which is less than -1 mV or greater than 1 mV. Thus, the pre-processing unit 120 may provide reconstructed data for detecting whether the voltage data of the battery management apparatus 100 is obtained from the normal battery cell or from the abnormal battery cell, or is voltage data including noise, by obtaining the voltage data reconstructed from the voltage data.

In another aspect, the pre-processing unit 120 may normalize a range of voltage data of the plurality of battery cells 10 obtained in various environments to a specific range, thereby scaling a deviation of the voltage data to a consistent range. According to various embodiments, the voltage data of the plurality of battery cells 10 obtained in various charging/discharging sections may have a great deviation for each charging/discharging section or each battery cell. In this case, the pre-processing unit 120 may normalize the range of the voltage data of the plurality of battery cells 10 to a specific range. In this way, the battery management apparatus 100 may improve the reliability of noise processing and abnormal battery cell detection.

According to an embodiment, the pre-processing unit 120 may generate a plurality of sub data sets from the data set. For example, the pre-processing unit 120 may generate a plurality of sub data sets from the data set by using a moving window (or sliding window) scheme. Herein, the moving window (or sliding window) scheme may refer to an arbitrary scheme that extracts a partial data array while moving a fixed-size window along a data array. Thus, the pre-processing unit 120 may determine a size (or length) of the moving window (or sliding window) and a moving interval (i.e., a moving interval or a sliding interval) of the window.

According to an embodiment, the pre-processing unit 120 may determine a predetermined time section as the length of the window. For example, the length of the window may include at least 16 sensing time points. In this case, the length of sub data sets generated by the pre-processing unit 120 may equal to the length of the predetermined time section. According to an embodiment, the pre-processing unit 120 may generate the sub data sets by using a square (e.g., 16 x 16) matrix having a length (e.g., 16 time points) of the predetermined time section as a moving window.

According to an embodiment, the pre-processing unit 120 may determine the moving interval or the moving/sliding interval of the window. For example, the moving (or sliding) interval may include four sensing time points. In this case, the pre-processing unit 120 may generate a plurality of sub data sets while moving a 16 x 16 window by four spaces in a data set of 180 x 14.

According to an embodiment, the pre-processing unit 120 may obtain voltage data reconstructed from sub data sets. In this way, the pre-processing unit 120 may increase a sample that is a target for data decomposition, by generating a number of sub data sets from a limited data set. The pre-processing unit 120 may lower bias in data through the moving window scheme. Thus, the pre-processing unit 120 may obtain more reconstructed voltage data by obtaining reconstructed voltage data from sub data sets rather than obtaining reconstructed voltage data from a data set. Thus, the battery management apparatus 100 may more accurately detect an abnormal battery cell based on more reconstructed voltage data.

According to an embodiment, the pre-processing unit 120 may obtain the reconstructed voltage data using an arbitrary data processing algorithm. For example, the pre-processing unit 120 may obtain reconstructed voltage data by using a data decomposition algorithm. According to an embodiment, the data decomposition algorithm may be based on matrix decomposition. For example, the data decomposition algorithm may include a singular value decomposition (SVD) algorithm.

According to an embodiment, the pre-processing unit 120 may output, as reconstructed data, a data set or sub data sets obtained from the plurality of battery cells 10, by using SVD. In this way, the pre-processing unit 120 may normalize data obtained from each of the plurality of battery cells 10.

Referring back to FIGS. 1, 4, 5, and 6, the noise processing unit 130 may process noise from reconstructed voltage data. Herein, the noise may include noise of the sensor 12. In another aspect, characteristics of the reconstructed voltage data may include characteristics related to noise originating from the sensor 12. Thus, the noise processing unit 130 may pattern noise originating from the sensor 12 and cancel the noise based on the characteristics of the reconstructed voltage data. In this way, the noise processing unit 130 may generate battery cell data from which noise is canceled.

According to various embodiments, a specific sensor among the sensors 12 respectively connected to the plurality of battery cells 10 may have a higher noise level than another sensor. Thus, a deviation of the voltage signal obtained in the sensor 12 may increase. In this case, the battery management apparatus 100 may misdiagnose a voltage, measured in a sensor having a high noise level, as an abnormal voltage of a battery cell. Thus, the noise processing unit 130 may generate battery cell data by filtering noise from the voltage data of the battery cell. In this way, the battery management apparatus 100 may prevent misdiagnosis due to the noise of the sensor 12.

According to an embodiment, the noise processing unit 130 may perform noise processing based on the characteristics of the reconstructed voltage data. Herein, the characteristics of the reconstructed voltage data may be described based on a reconstructed voltage data graph shown in FIGS. 4 to 6. For example, the noise processing unit 130 may perform noise processing based on at least one of a profile of the reconstructed voltage data graph, the number of times of zero crossing, and a zero-crossing period.

According to an embodiment, the noise processing unit 130 may perform noise processing based on at least one of the number of times of zero crossing or and a zero-crossing period of the reconstructed voltage data. Herein, zero crossing may refer to a point at which the reconstructed voltage data traverses a specific voltage level in a predetermined time section. According to an embodiment, the specific voltage level may include 0. According to an embodiment, the noise processing unit 130 may determine zero crossing based on values of the voltage data reconstructed before and after the specific voltage level.

According to an embodiment, the noise processing unit 130 may compare the number of times of zero crossing of each of the reconstructed voltage data with a first threshold value and detect a noise component based on a result of the comparison. Herein, the first threshold value may be a value that is a criterion for distinguishing data related to a battery cell from noise-related data. The data related to the battery cell may include data related to the normal battery cell and data related to the abnormal battery cell.

According to an embodiment, the noise processing unit 130 may detect, as a noise component, reconstructed data having the number of times of zero crossing being greater than or equal to the first threshold value as a result of the comparison. For example, the first threshold value may be at least 2 (unit: times). In this case, the noise processing unit 130 may detect the reconstructed voltage data as the noise component when the number of times the reconstructed voltage data traverses 0 is greater than or equal to 2 in a predetermined time section. For example, the noise processing unit 130 may not detect the reconstructed voltage data S1 and S2 having the number of times of zero crossing being 1 as a noise component, and detect the reconstructed voltage data S3 having the number of times of zero crossing being 8 as a noise component.

According to an embodiment, the noise processing unit 130 may compare the zero-crossing period of each of the reconstructed voltage data with a second threshold value and detect a noise component based on a result of the comparison. Herein, the second threshold value may be a value that is a criterion for distinguishing data related to a battery cell from noise-related data. The data related to the battery cell may include data related to the normal battery cell and data related to the abnormal battery cell. In another aspect, a zero-crossing period may refer to a time interval between first zero crossing and second zero crossing in a predetermined time section.

According to an embodiment, the noise processing unit 130 may detect, as a noise component, reconstructed data having a zero-crossing period being less than or equal to the second threshold value as a result of the comparison. For example, the second threshold value may be at least 10 (unit: time point or sensing time point). In this case, the noise processing unit 130 may detect the reconstructed voltage data as a noise component when a time interval at which the reconstructed voltage data traverses 0 in the predetermined time section is less than or equal to 10 (unit: time point or sensing time point). For example, the noise processing unit 130 may not detect the reconstructed voltage data S1 and S2 having an infinite zero-crossing period as a noise component, and detect the reconstructed voltage data S3 having a zero-crossing period being 4 (or less) as a noise component.

According to an embodiment, the noise processing unit 130 may generate battery cell data by canceling the noise component from the reconstructed voltage data. In this way, the noise processing unit 130 may cancel noise related to the sensor 12 and generate voltage data related to a pure battery cell. Thus, the battery management apparatus 100 may reduce misdiagnosis of the sensor 12 due to noise and accurately detect an abnormal battery cell.

Referring back to FIGS. 1, 4, and 5, the abnormal cell detection unit 140 may detect the abnormal battery cell based on the battery cell data S1 and S2 generated from the noise processing unit 130. Herein, the battery cell data generated from the noise processing unit 130 may refer to reconstructed voltage data from which noise related to the sensor 12 is canceled.

Referring to FIGS. 4 and 5, the abnormal cell detection unit 140 may detect the abnormal battery cell based on a voltage deviation of each of the battery cell data S1 and S2. Herein, the voltage deviation may refer to a difference between a minimum value and a maximum value of a voltage of battery cell data in a predetermined time section.

According to an embodiment, the abnormal cell detection unit 140 may compare the voltage deviation of each of the battery cell data S1 and S2 with a third threshold value and detect the abnormal battery cell based on a result of the comparison. Herein, the third threshold value may be a value that is a criterion for distinguishing data related to a normal battery cell from data related to an abnormal battery cell.

According to various embodiments, reconstructed voltage data of an abnormal battery cell may have a voltage deviation greater than that of reconstructed voltage data of a normal battery cell. Thus, the abnormal cell detection unit 140 may detect the normal battery cell and the abnormal battery cell based on a voltage deviation of each of the battery cell data S1 and S2.

According to an embodiment, the abnormal cell detection unit 140 may detect, as an abnormal battery cell, a battery cell having a voltage deviation greater than or equal to the third threshold value as a result of the comparison. Herein, the third threshold value may be the same as a standard deviation of the reconstructed voltage data. For example, the third threshold value may be 1 (unit: mV). In this case, the abnormal cell detection unit 140 may detect the reconstructed voltage data as the abnormal battery cell when the voltage deviation of the reconstructed voltage data is at least 1 mV in the predetermined time section. For example, the abnormal cell detection unit 140 may detect the battery cell data S1 having a voltage deviation less than 1 mV as normal battery cell data and the battery cell data S2 having a voltage deviation greater than or equal to 1 mV as abnormal battery cell data.

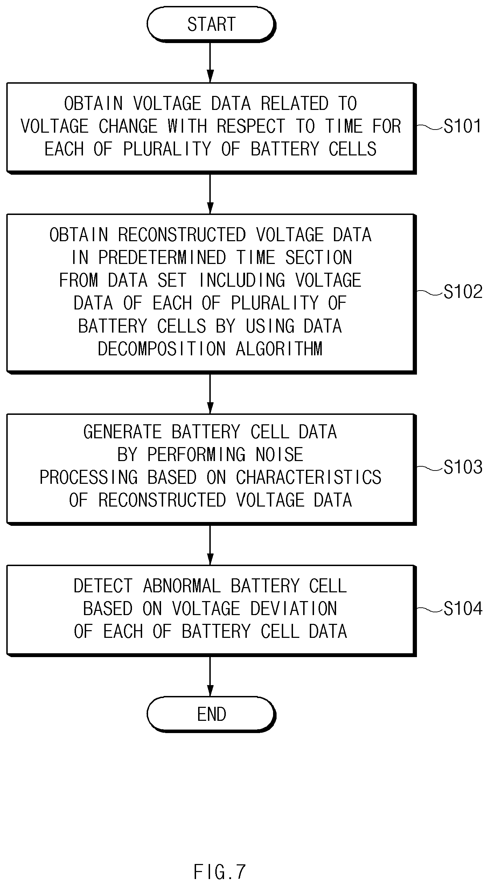

FIG. 7 is a flowchart showing an operation of a battery management apparatus according to an embodiment disclosed herein.

Referring to FIG. 7, the battery management apparatus 100 may obtain voltage data related to a voltage change with respect to time for each of a plurality of battery cells in operation S101, obtain reconstructed voltage data in a predetermined time section from a data set including the voltage data of each of the plurality of battery cells by using a data decomposition algorithm in operation S102, generate battery cell data by performing noise processing based on characteristics of the reconstructed voltage data in operation S103, and detect an abnormal battery cell based on a voltage deviation of each of the battery cell data in operation S104.

In operation S101, the data obtaining unit 110 of the battery management apparatus 100 may obtain the voltage data related to the voltage change with respect to time for each of the plurality of battery cells.

In operation S102, the pre-processing unit 120 of the battery management apparatus 100 may obtain the reconstructed voltage data in the predetermined time section from the data set including the voltage data of each of the plurality of battery cells, by using the data decomposition algorithm. According to an embodiment, the pre-processing unit 120 may generate a plurality of sub data sets of a length corresponding to the predetermined time section from the data set. The reconstructed voltage data may be obtained from each of the plurality of sub data sets based on the data decomposition algorithm.

In operation S103, the noise processing unit 130 of the battery management apparatus 100 may generate the battery cell data by performing noise processing based on the characteristics of the reconstructed voltage data. According to an embodiment, the noise processing unit 130 may detect a noise component based on at least one of the number of times of zero crossing and a zero-crossing period of each of the reconstructed voltage data. The noise processing unit 130 may generate battery cell data by canceling the noise component from the reconstructed voltage data.

In operation S104, the abnormal cell detection unit 140 of the battery management apparatus 100 may detect the abnormal battery cell based on the voltage deviation of each of the battery cell data.

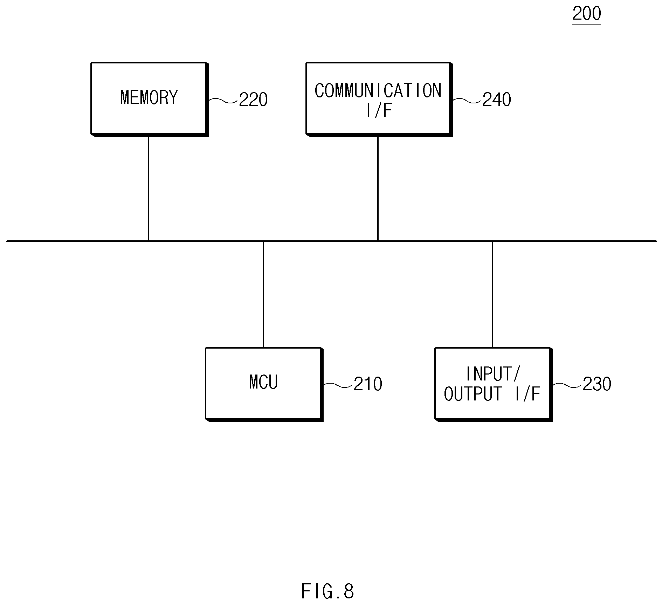

FIG. 8 is a block diagram showing a hardware configuration of a computing system for performing an operating method of a battery management apparatus, according to an embodiment disclosed herein.

Referring to FIG. 8, a computing device 200 according to an embodiment disclosed herein may include a microcontroller unit (MCU) 210, a memory 220, an input/output interface (I/F) 230, and a communication I/F 240.

The MCU 210 may be a processor that executes various programs (e.g., a battery cell data collection program, a graph calculation program, a data analysis program, a data decomposition algorithm, a normalization program, a battery cell diagnosis program, etc.) stored in the memory 220, processes various information including feature data, potential variables, etc., of the battery cell through these programs, and executes the above-described functions of the controller included in the battery management apparatus 100 shown in FIGS. 1 to 7.

The memory 220 may store various programs such as a battery cell data collection program, a graph calculation program, a data analysis program, a data decomposition algorithm, a normalization program, a battery cell diagnosis program, etc.

The memory 220 may be provided in plural, depending on a need. The memory 220 may be a volatile or nonvolatile memory. For the memory 220 as the volatile memory, random access memory (RAM), dynamic RAM (DRAM), static RAM (SRAM), etc., may be used. For the memory 220 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 220 are merely examples and are not limited thereto.

The input/output I/F 230 may provide an interface for transmitting and receiving data by connecting an input device (not shown) such as a keyboard, a mouse, a touch panel, etc., and an output device such as a display (not shown), etc., with the MCU 210.

The communication I/F 240, which is a component capable of transmitting and receiving various data to and from a server, may be various devices capable of supporting wired or wireless communication. For example, the battery management apparatus 100 may transmit and receive various information including a shape model, etc., of the battery cell from an external server separately provided through the communication I/F 240.

As such, a computer program according to an embodiment disclosed herein may be recorded in the memory 220 and processed by the MCU 210, thus being implemented as a module that performs functions shown in FIG. 2.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The foregoing disclosure may roughly show features of several embodiments to allow those of ordinary skill in the art to better understand aspects of the present disclosure. Those of ordinary skill in the art will appreciate that they may readily use the present disclosure as a basis for designing or modifying other structures to carry out the same purposes or achieve the same advantages of the embodiments introduced herein. Additionally, it would be recognized by those of ordinary skill in the art that such equivalent configurations may not depart from the scope of the present disclosure, and various changes, substitutions, and modifications may be made herein without departing from the scope of the present disclosure.

### [EXPLANATION OF REFERENCE NUMERALS DESIGNATING THE MAJOR ELEMENTS OF THE DRAWINGS]

1: BATTERY PACK
2: HIGHER-LEVEL CONTROLLER
10: PLURALITY OF BATTERY CELLS
12: SENSOR
14: SWITCHING UNIT
20: BMS
100: BATTERY MANAGEMENT APPARATUS
110: DATA OBTAINING UNIT
120: PRE-PROCESSING UNIT
130: NOISE PROCESSING UNIT
140: ABNORMAL CELL DETECTION UNIT
200: COMPUTING SYSTEM
210: MCU
220: MEMORY
230: INPUT/OUTPUT I/F
240: COMMUNICATION I/F

## Claims

1. A battery management apparatus comprising:
a data obtaining unit configured to obtain voltage data related to a voltage change with respect to time for each of a plurality of battery cells;
a pre-processing unit configured to obtain reconstructed voltage data in a predetermined time section from a data set comprising the voltage data of each of the plurality of battery cells, by using a data decomposition algorithm;
a noise processing unit configured to generate battery cell data by performing noise processing based on characteristics of the reconstructed voltage data; and
an abnormal cell detection unit configured to detect an abnormal battery cell based on a voltage deviation of each of the battery cell data.

2. The battery management apparatus of claim 1, wherein the pre-processing unit is further configured to:
generate a plurality of sub data sets having a length corresponding to the predetermined time section from the data set; and
obtain the reconstructed voltage data from each of the plurality of sub data sets based on the data decomposition algorithm.

3. The battery management apparatus of claim 2, wherein the data decomposition algorithm comprises singular value decomposition (SVD).

4. The battery management apparatus of claim 1, wherein the noise processing unit is further configured to perform the noise processing with respect to each of the reconstructed voltage data based on a number of times of zero crossing that is a number of times a voltage traverses a specific voltage level.

5. The battery management apparatus of claim 4, wherein the noise processing unit is further configured to:
compare the number of times of zero crossing of each of the reconstructed voltage data with a first threshold value;
detect, as a noise component, reconstructed data having the number of times of zero crossing being greater than or equal to the first threshold value; and
generate the battery cell data by canceling the noise component from the reconstructed voltage data.

6. The battery management apparatus of claim 5, wherein the specific voltage level comprises 0.

7. The battery management apparatus of claim 1, wherein the noise processing unit is further configured to perform the noise processing with respect to each of the reconstructed voltage data based on a zero-crossing period that is a period in which a voltage traverses a specific voltage level.

8. The battery management apparatus of claim 7, wherein the noise processing unit is further configured to:
compare the zero-crossing period of each of the reconstructed voltage data with a second threshold value;
detect, as a noise component, the reconstructed data having the zero-crossing period being less than or equal to the second threshold value; and
generate the battery cell data by canceling the noise component from the reconstructed voltage data.

9. The battery management method of claim 8, wherein the specific voltage level comprises 0.

10. The battery management apparatus of claim 1, wherein the abnormal cell detection unit is further configured to:
compare a voltage deviation, which is a difference between a minimum value and a maximum value of a voltage of each of the battery cell data in the predetermined time section, with a third threshold value; and
detect, as an abnormal battery cell, a battery cell having the voltage deviation being greater than or equal to the third threshold value.

11. A battery management method comprising:
obtaining voltage data related to a voltage change with respect to time for each of a plurality of battery cells;
obtaining reconstructed voltage data in a predetermined time section from a data set comprising the voltage data of each of the plurality of battery cells, by using a data decomposition algorithm;
generating battery cell data by performing noise processing based on characteristics of the reconstructed voltage data; and
detecting an abnormal battery cell based on a voltage deviation of each of the battery cell data.

12. The battery management method of claim 11, wherein the obtaining of the reconstructed voltage data comprises:
generating a plurality of sub data sets having a length corresponding to the predetermined time section from the data set; and
obtaining the reconstructed voltage data from each of the plurality of sub data sets based on the data decomposition algorithm.

13. The battery management method of claim 12, wherein the data decomposition algorithm comprises singular value decomposition (SVD).

14. The battery management method of claim 11, wherein the generating of the battery cell data comprises performing the noise processing with respect to each of the reconstructed voltage data based on a number of times of zero crossing that is a number of times a voltage traverses a specific voltage level.

15. The battery management method of claim 14, further comprising:
comparing the number of times of zero crossing of each of the reconstructed voltage data with a first threshold value;
detecting, as a noise component, reconstructed data having the number of times of zero crossing being greater than or equal to the first threshold value; and
generating the battery cell data by canceling the noise component from the reconstructed voltage data.

16. The battery management method of claim 15, wherein the specific voltage level comprises 0.

17. The battery management method of claim 11, wherein the generating of the battery cell data comprises performing the noise processing with respect to each of the reconstructed voltage data based on a zero-crossing period that is a period in which a voltage traverses a specific voltage level.

18. The battery management method of claim 17, further comprising:
comparing the zero-crossing period of each of the reconstructed voltage data with a second threshold value;
detecting, as a noise component, reconstructed data having a zero-crossing period being less than or equal to the second threshold value; and
generating the battery cell data by canceling the noise component from the reconstructed voltage data.

19. The battery management method of claim 18, wherein the specific voltage level comprises 0.

20. The battery management method of claim 11, wherein the detecting of the abnormal battery cell comprises:
comparing a voltage deviation, which is a difference between a minimum value and a maximum value of a voltage of each of the battery cell data in the predetermined time section, with a third threshold value; and
detecting, as an abnormal battery cell, a battery cell having the voltage deviation being greater than or equal to the third threshold value.
